Europäisches Patentamt

European Patent Office

Office européen des brevets

(19)

(11) Publication number : **0 336 058 B1**

(12) **EUROPEAN PATENT SPECIFICATION**

(45) Date of publication of patent specification :
15.04.92 Bulletin 92/16

(51) Int. Cl.⁵: **B24B 7/06, H05K 3/26**

(21) Application number : **89101386.4**

(22) Date of filing : **27.01.89**

(54) **An apparatus for surface grinding of planar members.**

(30) Priority : **25.03.88 JP 71168/88**

(43) Date of publication of application :
**11.10.89 Bulletin 89/41**

(45) Publication of the grant of the patent :
**15.04.92 Bulletin 92/16**

(84) Designated Contracting States :
**BE DE ES FR GB IT NL**

(56) References cited :
**DE-A- 2 331 646**
**DE-A- 2 452 700**
**DE-A- 2 800 217**
**DE-C- 820 888**
**GB-A- 2 053 043**

(56) References cited :
**US-A- 1 331 984**
**US-A- 2 548 979**
**US-A- 3 636 662**
**US-A- 3 734 700**

(73) Proprietor : **Nippon CMK Corp.**
**1106 Fujikubo Miyoshi-Chou**
**Iruma-Gun Saitama (JP)**

(72) Inventor : **Seki, Kameharu**
**5240-94 Kasahata**
**Kawagoe-Shi Saitama (JP)**
Inventor : **Kubo, Isamu**
**3039-2 Sinmach**
**Isesaki-Shi Gunma (JP)**

(74) Representative : **Schickedanz, Willi, Dipl.-Ing.**
**Langener Strasse 68**
**W-6050 Offenbach/Main (DE)**

# Description

The present invention relates to an apparatus for surface grinding of planar members. The present invention is developed as an apparatus for surface grinding of printed wiring boards for surface treatment as one of the manufacturing processes thereof, however, the apparatus can generally be applied to planar members.

## Description of the Prior Art

Conventionally, surface grinding of planar members is performed by a rotary brush or by a rotary stone. However, as kinetic energy changes from the center portion to peripheral portion of such a brush, the ground surface cannot be uniform when the plane surface of such a tool contacts with the member, and also, as the contact surface of the tool is too small when the peripheral surface contacts with the planar member, the ground surface also is not uniform.

To solve the above mentioned disadvantage, Japanese Patent Application No. 62-283368 of November 10, 1987 "Method of Surface Grinding of Planar Member" discloses a method of surface grinding of a planar member by a grinding tool which moves eccentrically on a plane.

All portions of an eccentrically moving planar tool, e. g. of a brush, have the same kinetic energy, in contrast to a rotary brush, so that the same grinding effect is applied to the surface to be ground. Thus, a uniform ground surface can be obtained and results in a uniform wear of brush.

## Disadvantages of the Prior Art

All grinding devices of the prior art perform only one function which is regarded as natural from construction and purpose. However, when quantity to be ground is very small, e. g. grinding brush and grinding stone, it is desirable to combine two grinding functions in one tool so as to perform two functions by one process continuously.

## Technical Problem

The object of the present invention is to solve the above mentioned problem, and to provide an improved grinding apparatus to perform two grinding functions continuously by one device which may comprise a brush and a grinding stone.

A conventional rotary grinding head can never have two functions, and only the above mentioned surface grinding device having a rectangular grinding member of substantially planar grinding surface supported through an eccentric shaft to perform plane eccentric motion can allow constructional possibility.

## Solution of the Technical Problem

According to the apparatus, the grinding member has a substantially rectangular plane grinding surface which consists of a first and a second grinding means which are different form each other and is driven simultaneously by one eccentric shaft.

Preferably, said first grinding member is a brush, and said second grinding member is a grinding stone which is downstream side from the brush.

Preferably, urging forces to said first and second grinding members are regulatable independently.

Preferably, said first grinding member includes a plurality of bundles of brush and means to inject water to the surface.

## Advantageous Effects of the Invention

The grinding member having two different grinding means and driven by one eccentric shaft, according to the present invention, performs two grinding processes on one table so that surface finishing process of planar member is simplified.

## Brief Description of the Drawings

Figure 1 is a perspective view of a surface grinding apparatus for surface grinding of printed wiring boards, according to one embodiment of the present invention.

Figure 2 is a schematic front view of a portion of Fig. 1.

Figure 3 is a perspective view of a portion of Fig. 1 showing the surface grinding of a printed wiring board.

Figure 4 is a plan view of a brush and a grinding stone, according to another embodiment of the present invention, and

Figure 5 is an end view of Fig. 4.

## Detailed Description of the Preferred Embodiments

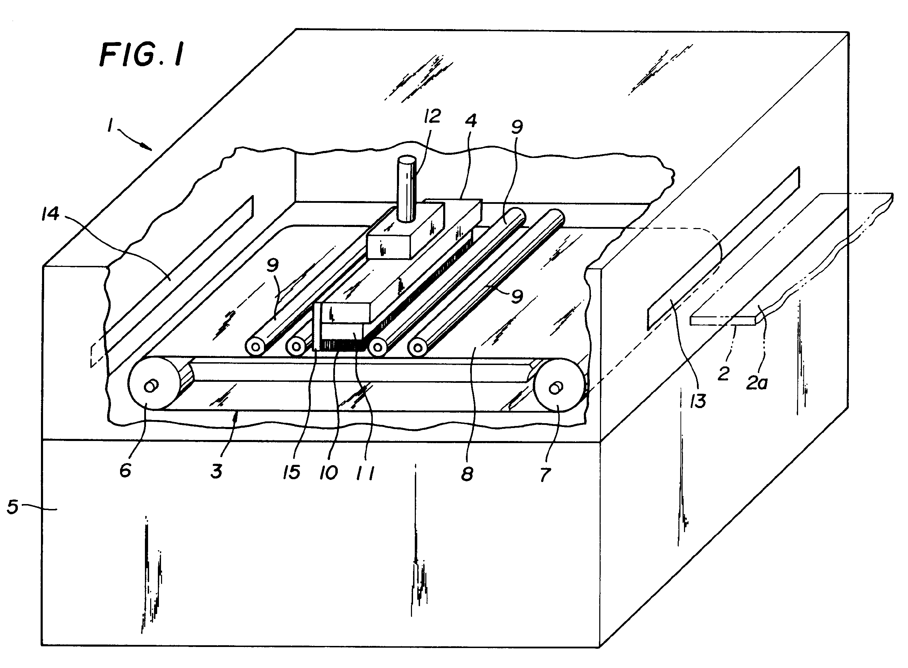

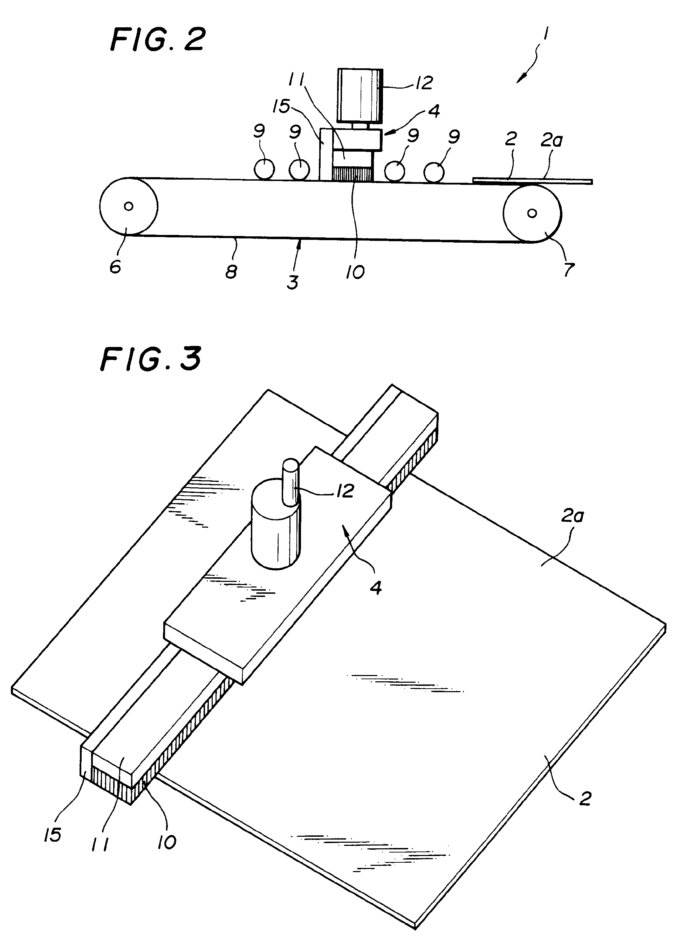

Fig. 1 illustrates a surface grinding apparatus 1 including a conveyor device 3 to convey printed wiring boards 2 as shown in Fig. 2, a grinding device 4 to grind a surface 2a of a printed wiring board 2 which is conveyed by the conveyor device 3, and an apparatus body 5 comprising the conveyor device 3 and the grinding device 4.

The conveyor device 3 includes rotatably supported two conveyor rolls 6 and 7, and an endless belt 8 wound around the rolls 6 and 7. Guide rolls 9 guide the printed wiring boards 2 on the belt 8. An eccentric shaft 12 drives a brush support 11 with a brush body 10 eccentrically on one plane so that every portion of the brush body 10 receives same kinetic energy.

According to the present invention, the grinding device 4 includes the brush body 10, the brush support 11, a grinding stone 15 which is downstream from and parallel with the brush body 10, and the eccentric shaft 12 secured with the brush support 11. The brush body 10 is attached under the relatively long and rectangular planar brush support 11. The brush support 11 and the grinding stone 15 are driven eccentrically through the eccentric shaft 12. The brush support 11 and the grinding stone 15 are supported such that the urging forces to grind the surface 2a of the printed wiring board 2 can be regulatable. However, the brush support 11 and the grinding stone 15 may be secured with each other as desired when only the urging force of the grinding stone 15 is to be regulated.

As the brush support 11 and the grinding stone 15 are driven by the eccentric shaft 12 on one plane, the upstream side brush body 10 forms grinding traces on the surface of the printed wiring board 2 uniformly and the downstream side grinding stone 15 forms smooth ground surface smoothing out the ground traces of the brush 10.

On both sides of the apparatus body 5, inlet and outlet openings 13 and 14 are formed to supply and discharge the printed wiring boards.

The process of grinding the surface 2a of the printed wiring board 2 by the surface grinding apparatus 1 will now be described.

At first, printed wiring boards 2 to be surface finished are supplied through the opening 13. The supplied printed wiring boards 2 are fed sequentially through the conveyor device 3 to the grinding device 4.

The brush body 10 and the grinding stone 15 are driven eccentrically on a plane through the eccentric shaft 12 to grind the surface 2a of the printed wiring board 2. The eccentric motion of the brush body 10 and the grinding stone 15 forms generally brush traces on the surface 2a by the upstream side brush 10, and then the brush traces are ground off by the downstream grinding stone 15.

Then, the surface finished printed wiring board 2 is conveyed by the conveyor belt 8 to the discharge outlet 14.

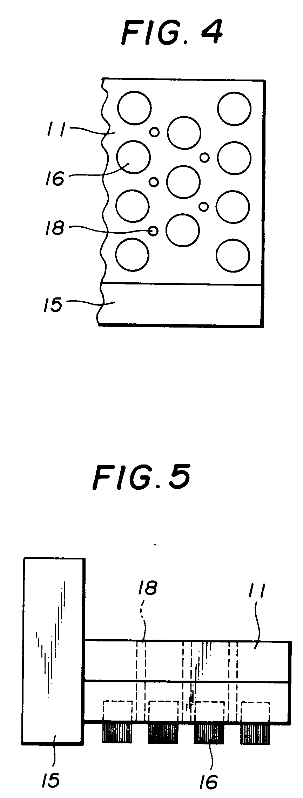

Figs. 4 and 5 show another embodiment which is preferable to surface grind relatively soft material e. g. copper clad on the printed wiring board 2. The same reference numerals show the same or a similar part or portion as compared with the first embodiment.

The brush 10 includes many brush bundles 16 and the fibers forming the bundle 16 contain grinding material. The brush body 11 has many water feed openings 18 to inject water from a water supply, not shown. The grinding stone 15 which is parallel with the brush body 11 is a rubber grinding stone in the embodiment shown. The arrangement can be used as parallel two different grinding means without necessitating a precise relative position regulating device to obtain the required surface finish.

As described in detail, according to the present invention, the planar brush body 10 and the parallel grinding stone 15 are simultaneously and eccentrically driven by one eccentric shaft 12 on one plane so that uniform brush traces are formed upstream side by the brush 10 and the brush traces are smoothed out by the downstream side grinding stone 15. Thus, the surface 2a of the printed wiring board 2 can be surface finished by one process, and the finished surface is sufficient to perform later processes of good laminate adhering, good printing ink border and good fine pattern forming.

Further, as the brush is planar, in contrast to conventional circular brush, the brush can be manufactured easily to reduce manufacturing cost. Also, as the apparatus is essentially an apparatus to perform one grinding function so that simple and cheap construction and short working line can be realized.

Also, in the embodiment shown in Fig. 1, the grinding brush device 4 may include water injection means, not shown, to inject high pressure water into the brush body 10 to wash out copper powder and debris from the surface 2a of the printed wiring board to obtain clean finish.

In a preferred embodiment of the invention the length of the brush 10 is approximately seven turns larger than its width. The grinding stone 15 is in a vertical position, whereas the brush support 11 is in an horizontal position. In this case the brush 10 as such is arranged at the lower side of the brush support 11. A sectional view through the combination of the brush support 11, the brush and the grinding stone 15 shows a parallelepipedon. The upper portions of the grinding stone 15 and of the brush support are connected to a member 4 the length of which is approximately 50 % of the combined lengths of the brush support 11 and of the grinding stone 15, whereas the width of it is about 150 % of the width of the combination of grinding stone and brush support.

The brush support comprises, as shown in Fig. 4, a plurality of equidistant holes 16 each of which includes bundles of fibers as shown in Fig. 5.

To bring the wiring boards 2 to and from the grinding device 4, two guide rolls 9 are provided on each side of the grinding device. These guide rolls 9 press the wiring boards 2 down to the upper portion of the endless belt 8.

As described, according to the present invention, two different kinds of plane finishing process can be performed by only one work shaft simply and accurately. Thus, simple apparatus, easy working, low cost, and accurate finishing can be realized.

## Claims

1. A surface grinding apparatus (1) of a planar member (2) including a grinding means (4) having substantially plane grinding surface and an eccentric shaft (12) supporting the grinding means (4) eccentrically movable on a plane, **characterized in that** said grinding means (4) is substantially rectangular in plan view and formed by parallel and different first and second grinding members (11, 10; 15) which are driven simultaneously by the eccentric shaft (12).

2. A surface grinding apparatus (1) according to claim 1, **characterized in that** said first grinding member is a brush (10), and said second grinding member is a grinding stone (15) which is downstream side from the brush (10).

3. A surface grinding apparatus according to claim 1 or 2, **characterized in that** urging forces to said first and second grinding members (10, 11; 15) are regulatable independently.

4. A surface grinding apparatus (1) according to claim 1 or 2, **characterized in that** said first grinding member (10) includes a plurality of bundles (16) of brush and means (18) to inject water to the surface.

5. A surface grinding apparatus (1) according to claim 2, **characterized in that** the length of the brush (10) is approximately seven times larger than its width.

6. A surface grinding apparatus (1) according to claim 2, **characterized in that** the grinding stone (15) is in a vertical position whereas a brush support (11) is in a horizontal position, whereby the brush (10) is arranged at the lower side of said brush support (11), and that the brush support (11), the brush (10) and the grinding stone (15) form in a sectional view a rectangular parallelepipedon.

7. A surface grinding apparatus (1) according to claim 1 or any other of the preceding claims, **characterized in that** the upper portions of the grinding stone (15) and of the brush support (11) are connected to member (4) the length of which is approximately 50 % of the lengths of the brush support (11) and of the grinding stone (15) and the width of which is about 150 % of the width of the combined arrangement of the grinding stone (15) and the brush support (11).

8. A surface grinding apparatus (1) according to claim 1 or any other of the preceding claims, **characterized in that** the brush support (11) comprises a plurality of equidistant holes (16, Fig. 4), said holes (16) being capable of including bundles of fibers (16, Fig. 5).

9. A surface grinding apparatus (1) according to claim 1, **characterized in that** said apparatus comprises

a) an apparatus body (5);
b) slots (13, 14) in said apparatus body (15) for inserting and taking away planar members (2), the surfaces (2a) of which are to be grinded;
c) conveyor means (3) for conveying said planar members (2) from a first slot (13) to said grinding means (4);
d) guide rolls (9) for grinding said planar members (2) on said conveying means (3).

10. A surface grinding apparatus (1) according to claim 9, **characterized in that** the conveyor means (3) comprises an endless belt (8) wound around rolls (6, 7) defining the ends of said conveyor means (3), whereby said guide rolls (9) are arranged on the left and right sides of said grinding device (4) and close to the surface of the upper portion of the endless belt (8).

**Revendications**

1. Dispositif de meulage de surface (1) d'un élément plan (2) comprenant un moyen de meulage (4) ayant une surface de meulage sensiblement plane et un arbre excentrique (12) supportant le moyen de meulage (4) mobile de manière excentrique dans le plan, caractérisé en ce que ledit moyen de meulage (4) est sensiblement rectangulaire en vue en plan et formé par un premier et un second éléments de meulage (11, 10 ; 15) parallèles et différents qui sont entraînés simultanément par l'arbre excentrique (12).

2. Dispositif de meulage de surface (1) selon la revendication 1, caractérisé en ce que ledit premier élément de meulage est une brosse (10), et ledit second élément de meulage est une pierre à meuler (15) qui est sur le côté aval de la brosse (10).

3. Dispositif de meulage de surface slon l'une quleconque des revendications 1 ou 2, caractérisé en ce que des forces de poussée destinées auxdits premier er second éléments de meulage (10, 11 ; 15) sont réglables indépendamment.

4. Dispositif de meulage de surface (1) selon l'une quelconque des revendications 1 ou 2, caractérisé en ce que ledit premier élément de meulage (10) comprend une pluralité de faisceaux (16) de brosse et un moyen (18) pour injecter de l'eau sur la surface.

5. Dispositif de meulage de surface (1) selon la revendication 2, caractérisé en ce que la longueur de la brosse (10) est approximativement sept fois plus grande que sa largeur.

6. Dispositif de meulage de surface (1) selon la revendication 2, caractérisé en ce que la pierre à meuler (15) est en position verticale alors qu'un support de brosse (11) est en position horizontale, la brosse (10) étant disposée sur la face inférieure dudit support de brosse (11), et en ce que le support de brosse (11), la brosse (10) et la pierre à meuler (15) forment en vue en coupe un parallélépipède rectangle.

7. Dispositif de meulage de surface (1) selon l'une quelconque des revendications précédentes, caractérisé en ce que les portions supérieures de la pierre à meuler (15) et du support de brosse (11) sont reliées à l'élément (4) dont le longueur représente environ 50% des longueurs du support de brosse (11) et de la pierre à meuler (15) et dont la largeur représente environ 150% de la largeur de la combinaison de la pierre à meuler (15) et du support de brosse (11).

8. Dispositif de meulage de surface (1) selon l'une quelconque des revendications précédentes, caractérisé en ce que le support de brosse (11) comporte une pluralité de trous équidistants (16, Fig. 4), lesdits trous (16) pouvant comprendre des faisceaux de fibres (16 Fig. 5).

9. Dispositif de meulage de surface (1) selon la revendication 1, caractérisé en ce que ledit dispositif comporte

a) un corps de dispositif (5) ;

b) des fentes (13, 14) dans ledit corps de dispositif (15) pour insérer et retirer des éléments plans (2), dont les surfaces (2a) doivent être rectifiées ;

c) un moyen formant convoyeur (3) pour transporter lesdits éléments plans (2) d'une première fente (13) auxdits moyens de meulage (4) ;

d) des rouleaux-guides (9) pour rectifier lesdits éléments plans (2) sur ledit moyen formant convoyeur (3).

10. Dispositif de meulage de surface (1) selon selon la revendications 9, caractérisé en ce que le moyen formant convoyeur (3) comporte une courroie circulaire (8) enroulée autour de rouleaux (6, 7) définissant les extrémités dudit moyen formant convoyeur (3), lesdits rouleaux-guides (9) étant disposés sur les côtés gauche et droit dudit dispositif de rectification (4) et près de la surface de la portion supérieure de la courroie circulaire (8).


**Patentansprüche**

1. Ein Oberflächenschleifgerät (1) für ein ebenes Bauteil (2), mit einem Schleifgerät (4), das eine im wesentlichen ebene Schleifoberfläche besitzt, und mit einer das Schleifgerät (4) tragenden Exzenterwelle (12), welche exzentrisch in einer Ebene bewegbar ist, **dadurch gekennzeichnet, daß das** Schleifgerät (4) in der Draufsicht im wesentlichen rechteckig ist und von parallelen und unterschiedlichen ersten und zweiten Schleifelementen (11, 10; 15) gebildet ist, die gleichzeitig von der Exzenterwelle (12) angetrieben werden.

2. Ein Oberflächenschleifgerät (1) nach Anspruch 1, **dadurch gekennzeichnet**, daß das erste Schleifelement eine Bürste (10) ist, während das zweite Schleifelement ein Schleifstein (15) ist, der sich in Bewegungsrichtung vor der Bürste (10) befindet.

3. Ein Oberflächenschleifgerät nach Anspruch 1 oder 2, **dadurch gekennzeichnet**, daß die auf die ersten und zweiten Schleifelemente (10, 11; 15) wirkenden Druckkräfte unabhängig voneinander einstellbar sind.

4. Ein Oberflächenschleifgerät (1) nach Anspruch 1 oder 2, **dadurch gekennzeichnet**, daß das erste Schleifelement (10) mehrere Borstenbündel (16) und eine Vorrichtung (18) zum Spritzen von Wasser auf die Oberfläche aufweist.

5. Ein Oberflächenschleifgerät (1) nach Anspruch 2, **dadurch gekennzeichnet**, daß die Länge der Bürste (10) etwa sieben mal größer ist als ihre Breite.

6. Ein Oberflächenschleifgerät (1) nach Anspruch 2, **dadurch gekennzeichnet**, daß sich der Schleifstein (15) in einer senkrechten Lage befindet, während sich eine Bürstenhalterung (11) in einer waagerechten Lage befindet, wobei die Bürste (10) auf der Unterseite der Bürstenhalterung (11) angebracht ist, und daß die Bürstenhalterung (11), die Bürste (10) und der Schleifstein (15) im Querschnitt ein rechteckiges Parallelepiped bilden.

7. Ein Oberflächenschleifgerät (1) nach Anspruch 1 oder einem anderen der vorangegangenen Ansprüche, **dadurch gekennzeichnet**, daß die oberen Bereiche des Schleifsteins (15) und der Bürstenhalterung (11) mit dem Element (4) verbunden sind, dessen Länge etwa 50 % der Längen der Bürstenhalterung (11) und des Schleifsteins (15) und dessen Breite etwa 150 % der Breite der kombinierten Anordnung des Schleifsteins (15) und der Bürstenhalterung (11) beträgt.

8. Ein Oberflächenschleifgerät (1) nach Anspruch 1 oder einem anderen der vorangegangenen Ansprüche, **dadurch gekennzeichnet**, daß die Bürstenhalterung (11) mehrere Löcher (16, Fig. 4) gleichen Abstands aufweist, wobei die Löcher (16) Borstenbündel (16, Fig. 5) enthalten können.

9. Ein Oberflächenschleifgerät (1) nach Anspruch 1, **dadurch gekennzeichnet**, daß das Gerät umfaßt

a) einen Gerätekörper (5);

b) Schlitze (13, 14) in dem Gerätekörper (5) zum Einführen und Entnehmen von ebenen Bauteilen (2), deren Oberflächen (2a) geschliffen werden sollen;

c) eine Fördereinrichtung (3) zum Befördern der ebenen Bauteile (2) von einem ersten Schlitz (13) zu dem Schleifgerät (4);

d) Führungsrollen (9) zum Schleifen der ebenen Bauteile (2) auf der Fördereinrichtung (3).

10. Ein Oberflächenschleifgerät (1) nach Anspruch 9, **dadurch gekennzeichnet**, daß die Fördereinrichtung (3) ein Endlosband (8) umfaßt, das um Rollen (6, 7) geschlungen ist, welche die Enden der Fördereinrichtung (3) definieren, wobei die Führungsrollen (9) auf der linken und rechten Seite der Schleifvorrichtung (4) und in der Nähe der Oberfläche des oberen Bereichs des Endlosbands (8) angeordnet sind.

FIG. 1

EP 0 336 058 B1

# FIG. 2

# FIG. 3

# FIG. 4

# FIG. 5